# EUROPEAN PATENT APPLICATION

(11) **EP 4 071 837 A1**
(43) Date of publication of application: **12.10.2022**
(21) Application number: 20895038.6
(22) Date of filing: 02.12.2020
(51) Int. Cl.: H01L 33/38, H01L 23/48

(54) **FLIP LED CHIP, CIRCUIT BOARD AND ELECTRONIC DEVICE**

(30) Priority: 03.12.2019 CN 201911222587
(71) Applicant: Shenzhen Jufei Optoelectronics Co., Ltd., Guangdong 518111 (CN)
(72) Inventor: LIU, Yong, Shenzhen, Guangdong 518111 (CN); CHEN, Yanming, Shenzhen, Guangdong 518111 (CN); SUN, Pingru, Shenzhen, Guangdong 518111 (CN); XING, Meizheng, Shenzhen, Guangdong 518111 (CN)
(74) Representative: Viering, Jentschura & Partner mbB Patent- und Rechtsanwälte
(86) International application number: PCT/CN2020/133441
(87) International publication number: WO 2021/110065

(57) **Abstract**

A flip LED chip (20, 50, 70, 90, 102), a wiring board (100), and an electronic apparatus are provided. The bottom portion of the chip body (21, 51, 91) is provided with two pad slots (210, 710, 910) recessed upwardly, an N electrode pad (221, 921) and a P electrode pad (222, 922) are disposed on bottoms of the two pad slots (210, 710, 910), and a gap is between a side surface of each pad (22, 52, 72, 92) and a side wall of a corresponding pad slot (210, 710, 910). Therefore, upon soldering the flip LED chip (20, 50, 70, 90, 102) on the wiring board (100), the melted solder paste can penetrate the gap and bond to the side surface of the pad (22, 52, 72, 92). Therefore, the bonding between the solder paste and the pad (22, 52, 72, 92) can be achieved more sufficiently, thereby improving the reliability of soldering the flip LED chip (20, 50, 70, 90, 102) with the wiring board (100). Hence, the production yield of the flip LED chip (20, 50, 70, 90, 102) can be apparently improved.

## Description

### TECHNICAL FIELD

The present disclosure relates to the electrical field, and more particularly to a flip LED chip, a wiring board, and an electronic apparatus.

### RELATED ART

Regarding the application of mini LEDs, flip-chip printing is applied in the die-bonding procedure. In general, each of the wiring boards has thousands of or even millions of soldering spots for being connected to LED chips. Such huge number of soldering spots makes the packaging of the mini LEDs difficult. Owing to the requirements of densely arrangements of the LED chips, the chip size of the mini LEDs is of a micrometer scale. However, in the case that the pad size of the chip is less than 2000 µm², because the pad size of the chip is small, the contact area between the chip and the solder paste is also small. As a result, the bonding force between the chip pad and the solder paste is relatively small. Consequently, issues such as open circuit of the products, insufficient illumination of the products, blinking of the products, or the like thus occur, thus greatly affecting the product reliability.

### SUMMARY

In a flip LED chip, a wiring board, and an electronic apparatus according to one or some embodiments of the present disclosure, one of the issues to be solved is: the bonding force between the chip pad and the solder paste is relatively small owing that the pad size of the mini LED chip is small and thus greatly affecting the product reliability.

In view of this, one or some embodiments of the present disclosure provides a flip LED chip comprising a chip body and pads disposed on a bottom portion of the chip body; wherein the pads comprise an N electrode pad and a P electrode pad; the bottom portion of the chip body is provided with two pad slots recessed upwardly, the N electrode pad is disposed on a bottom of one of the two pad slots, the P electrode pad is disposed on a bottom of the other of the two pad slots, and a gap is between a side surface of each of the pads and a side wall of a corresponding pad slot of the two pad slots.

Optionally, according to one or some embodiments of the present disclosure, an absolute value of a difference between a height of each of the pads and a depth of the corresponding pad slot is less than or equal to 20 µm.

Optionally, according to one or some embodiments of the present disclosure, the height of each of the pads is less than or equal to the depth of the corresponding pad slot.

Optionally, according to one or some embodiments of the present disclosure, a cross-sectional area of each of the pads gradually decreases from the bottom portion of the corresponding pad slot to an opening of the corresponding pad slot distant from the bottom portion of the corresponding pad slot.

Optionally, according to one or some embodiments of the present disclosure, a longitudinal-sectional area of each of the pads is of an inverse isosceles trapezoidal shape or a rectangular shape.

Optionally, according to one or some embodiments of the present disclosure, for each of the pad slots, the side wall of the pad slot is perpendicular to the bottom surface of the chip body, or the cross-sectional area of the pad slot gradually increases from the bottom of the pad slot to the opening of the pad slot.

Optionally, according to one or some embodiments of the present disclosure, the gap between the side surface of each of the pads and the side wall of the corresponding pad slot gradually increases from the bottom portion of the corresponding pad slot to the opening of the corresponding pad slot distant from the bottom portion of the corresponding pad slot.

Optionally, according to one or some embodiments of the present disclosure, a friction coefficient of the bottom portion of each of the pads is greater than a friction coefficient of the bottom portion of the chip body.

Optionally, according to one or some embodiments of the present disclosure, the bottom surface and/or the side surface of each of the pads is zigzag-shaped or wavy-shaped.

According to an embodiment of the present disclosure, a wiring board is also provided and comprises a substrate and at least one flip LED chip mentioned in any one of the aforementioned embodiments; the pads of the at least one flip LED chip are soldered to a chip configuration region of the substrate and electrically connected to the circuitry inside the substrate.

According to an embodiment of the present disclosure, an electronic apparatus comprising the aforementioned wiring board is also provided.

The beneficial effect of the instant disclosure is described as following.

According to one or some embodiments of the present disclosure, a flip LED chip, a wiring board, and an electronic apparatus are provided. The flip LED chip comprises a chip and pads disposed on a bottom portion of the chip. The pads comprise an N electrode pad and a P electrode pad. The bottom portion of the chip body is provided with two pad slots recessed upwardly. The N electrode pad of the chip is disposed on a bottom of one of the two pad slots, the P electrode pad of the chip is disposed on a bottom of the other of the two pad slots, and a gap is between a side surface of each of the pads and a side wall of a corresponding pad slot of the two pad slots. Therefore, upon soldering the flip LED chip on the wiring board, the melted solder paste can penetrate the gap and bond to the side surface of the pad. Therefore, the bonding between the solder paste and the pad can be achieved more sufficiently, thereby improving the reliability of soldering the flip LED chip with the wiring board. Hence, the production yield of the flip LED chip can be apparently increased. Furthermore, for the wiring board and the electronic apparatus adopting the flip LED chip, the product reliability can be increased, the product service life can be prolonged, and the product quality can be increased.

Other features and corresponding beneficial effects of the present disclosure are described later in the specification, and it is understood that at least some of the beneficial effects become apparent from the specification of the present disclosure.

### BRIEF DESCRIPTION OF THE DRAWINGS

The present invention will become more readily apparent to those ordinarily skilled in the art after reviewing the following detailed description and accompanying drawings, in which:
Fig. 1 illustrates a schematic view of a flip LED chip known to the inventor;
Fig. 2a illustrates a schematic view showing the structure of a first type of a flip LED chip in accordance with an embodiment (1) of the present disclosure;
Fig. 2b illustrates a schematic view showing the structure of a second type of a flip LED chip in accordance with the embodiment (1) of the present disclosure;
Fig. 3a illustrates a schematic view showing the structure of a third type of a flip LED chip in accordance with the embodiment (1) of the present disclosure;
Fig. 3b illustrates a schematic view showing the structure of a fourth type of a flip LED chip in accordance with the embodiment (1) of the present disclosure;
Fig. 4 illustrates a schematic view showing the structure of a fifth type of a flip LED chip in accordance with the embodiment (1) of the present disclosure;
Fig. 5 illustrates a schematic view showing the structure of a sixth type of a flip LED chip in accordance with the embodiment (1) of the present disclosure;
Fig. 6 illustrates a schematic view of a pad in accordance with the embodiment (1) of the present disclosure;
Fig. 7 illustrates a schematic view showing the structure of a seventh type of a flip LED chip in accordance with the embodiment (1) of the present disclosure;
Fig. 8 illustrates a schematic view showing the structure of an eighth type of a flip LED chip in accordance with the embodiment (1) of the present disclosure;
Fig. 9 illustrates a schematic view showing the structure of a flip LED chip in accordance with an embodiment (2) of the present disclosure; and
Fig. 10 illustrates a schematic view showing the structure of a wiring board in accordance with an embodiment (3) of the present disclosure.

### DETAILED DESCRIPTION

In order to make the object, technical solutions, and advantages of the present disclosure more clearly understood, the following embodiments of the present disclosure are described in further detail by ways of specific embodiments in conjunction with the accompanying drawings. It should be understood that the specific embodiments described herein are intended only to explain the present disclosure and are not intended to limit it.

### Embodiment (1):

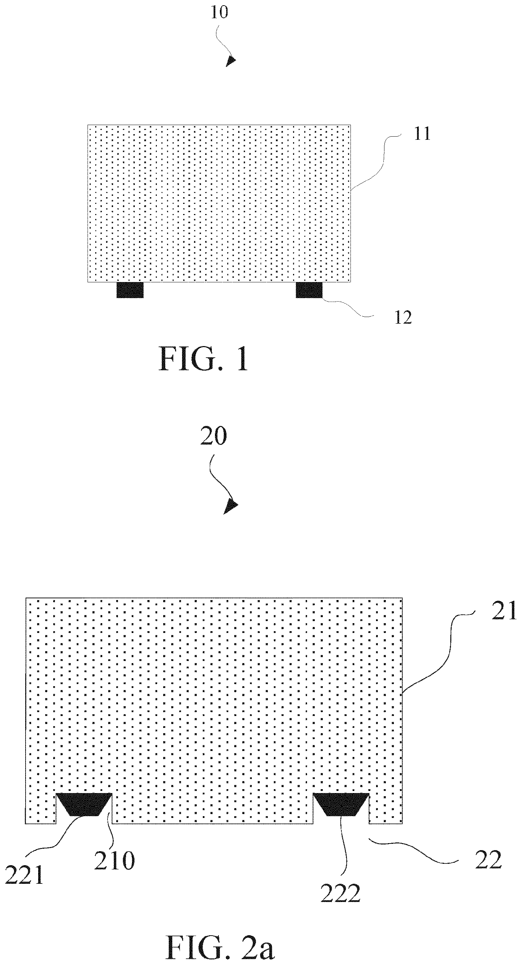

Please refer to Fig. 1. Fig. 1 illustrates a schematic view of a flip LED chip known to the inventor. The flip LED chip 10 includes a chip body 11 and pads 12. The pads 12 include an N electrode pad and a P electrode pad. The N electrode pad and the P electrode pad are isolated from each other through an insulated isolation belt. The chip body 11 may include a sapphire layer, an N-type current spreading layer, and a P-type current spreading layer, but these details are not shown in Fig. 1. As shown in Fig. 1, the pads 12 are disposed on the bottom portion of the chip body 11 and protruding outwardly. During the soldering process, the main portion of the pad 12 contacting the solder paste is the bottom portion of the pad 12. However, because the size of the flip LED chip 10 is small, the size of the pad 12 is even smaller. As a result, the actual contact area between the solder paste and the pad 12 is not very large. Consequently, after the bonding process, owing to the insufficient bonding between the solder paste and the pad 12, the flip LED chip 10 is prone to be detached off the wiring board. To address this problem, in one embodiment of the present disclosure, a flip LED chip is provided, as referring to a schematic view showing the structure of a flip LED chip shown in Fig. 2a.

The flip LED chip 20 comprises a chip body 21 and pads 22 on the bottom portion of the chip body 21. The chip body 21 may comprise an N-type current spreading layer and a P-type current spreading layer, and an intersection between the N-type current spreading layer and the P-type current spreading layer forms a P-N junction. Of course, the chip body 21 may comprise a transparent protection layer and a light-emitting layer.

Like the pad 10 of the flip LED chip 12 shown in Fig. 1, the pads 22 in this embodiment also comprise an N electrode pad 221 and a P electrode pad 222, and the N electrode pad 221 and the P electrode pad 222 are isolated with each other through an isolation belt made of insulative material(s).

The pads 22 are disposed on the bottom portion of the chip body 21. For example, in Fig. 2a, the bottom portion of the chip body 21 is provided with two pad slots 210 recessed upwardly. The N electrode pad 221 and the P electrode pad 222 are respectively disposed on bottom portions of the two pad slots 210, and a gap is between a side surface of the pad 22 and a side wall of the pad slot 210. Upon soldering the flip LED chip 20 on the wiring board with the solder paste, the melted solder paste can, not only bond to the bottom surface of the pad 22 but also penetrate the gap between the side surface of the pad 22 and the side wall of the pad slot 210, so that the solder paste, the side surface of the pad 22, and the side wall of the pad slot 210 can be bonded with each other. Accordingly, the contact area between the solder paste and the pad 22 can be increased, thereby improving the bonding between the solder paste and the pad 22 and the soldering reliability.

In some embodiments, the height h of the pad 22 is less than or equal to the depth d of the pad slot 210. Therefore, the pad 22 is in the pad slot 210. Because the pad 22 is disposed on the pad slot 210 which is recessed upwardly, the pad 22 can be considered as substantially "embedded" in the bottom portion of the chip body 21.

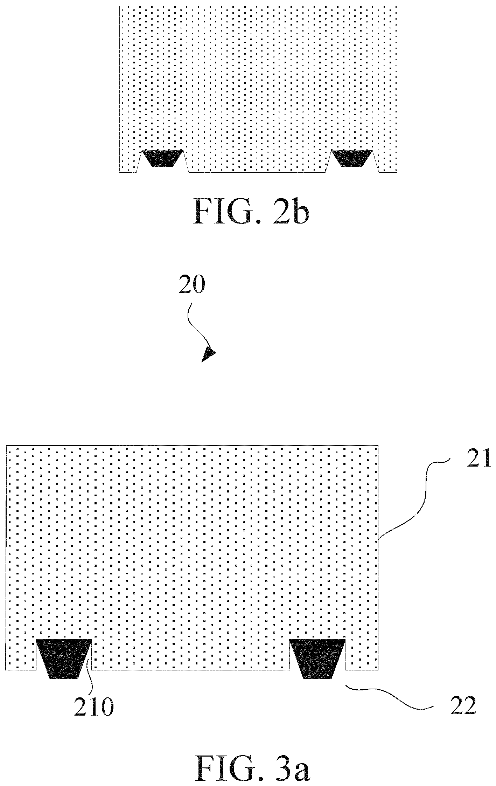

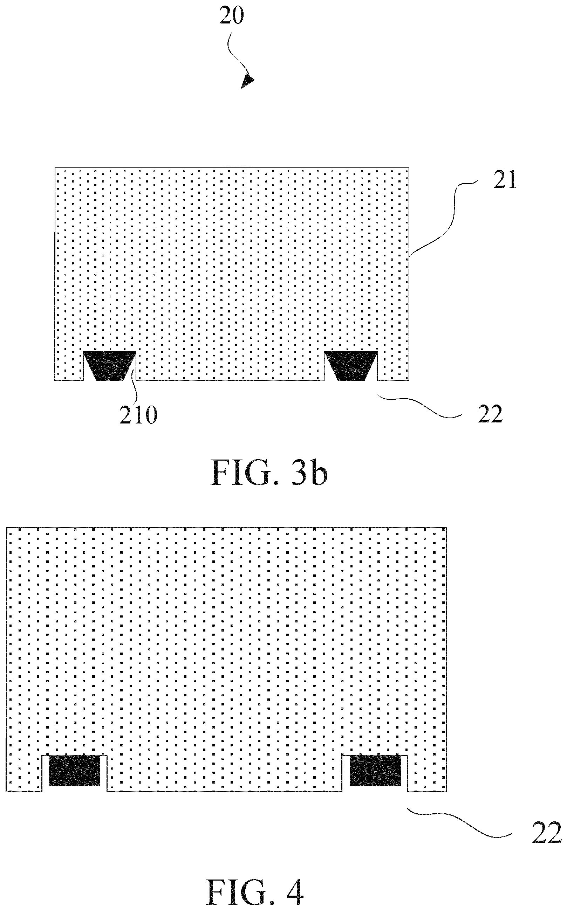

In some embodiments, the pad 20 may extend out of the pad slot 210; that is, the depth of the pad slot 210 is less than the height of the pad 22. Optionally, in some embodiments, the value of h-d is less than or equal to 20 µm. It is understood that, when the value of h-d is less than or equal to 20 µm, h is less than or equal to d. However, in some embodiments, h may be slightly greater than d as long as the value of h-d does not exceed 20 µm. For example, in Fig. 3a, the pad 22 slightly extends out of the opening of the pad slot 210. However, in some embodiments, in general, the height of the pad 22 is less than or equal to the depth of the pad slot 210; for example, in Fig. 3b, the depth of the pad slot 210 is the same as the height of the pad 22, while in Fig. 2a, the height of the pad 22 is less than the depth of the pad slot 210. It is understood that, as compared to the condition that the height of the pad 22 is equal to or greater than the depth of the pad slot 210, during the soldering process, in the flip LED chip 20 shown in Fig. 2a, the solder paste will penetrate the gap between the side wall of the pad slot 210 and the side surface of the pad 22 more easily. Hence, configuring the pad 22 not protruding out of the pad slot 210 will facilitate in further improving the soldering reliability.

In the flip LED chip according to some embodiments of the present disclosure, the shape of the longitudinal-sectional area of the pad 22 may be rectangular (for example, the flip LED chip shown in Fig. 4). Therefore, the pad 22 may be a cuboid, a cube, a prism, a cylinder, or the like. Under such configuration, the shapes and the areas of the cross-sectional areas at different portions of the pad 22 are the same. However, in some embodiments, as the flip LED chip shown in Fig. 2a, the cross-sectional areas at different portions of the pad 22 are not all the same. In Fig. 2a, the cross-sectional area of the pad 22 gradually decreases from the top to the bottom; that is, the cross-sectional area of the pad 22 gradually decreases from the bottom of the pad slot 210 to the opening of the pad slot 210 (which is distant from the bottom of the pad slot 210). The cross-sectional area of the pad 22 is of an inverse trapezoidal shape. In the flip LED chip, the side wall of the pad slot 210 is vertically configured (that is, the side wall of the pad slot 210 is perpendicular to the bottom surface of the chip body 21). Therefore, the gap between the pad slot 210 and the pad 22 gradually increases from the top to the bottom, and such configuration facilitates the entering of the solder paste. In Fig. 2a, the longitudinal-sectional area of the pad 22 is of an inverse isosceles trapezoidal shape. However, in some other embodiments, the longitudinal-sectional area of the pad 22 may be not of an inverse isosceles trapezoidal shape, but a normal trapezoidal shape.

In some embodiments, the side wall of the pad slot 210 may be not vertically configured. For example, Fig. 2b illustrates an LED chip, and in the LED chip, the cross-sectional area of the pad slot gradually increases from the bottom of the pad slot to the opening of the pad slot. In other words, in this embodiment, the side wall of the pad slot is inclined toward a direction away from the pad along the bottom of the pad slot to the opening of the pad slot.

Although in Fig. 2b, the pad is of an inverse trapezoidal shape, it is undoubted that, in some embodiments, the longitudinal-sectional area of the pad 22 may be of a rectangular shape, and the pad 22 may be a cuboid, a cube, a prism, a cylinder, or the like.

It is understood that, the improvement of the bonding between the solder paste and the pad can also be achieved by modifying the friction coefficient of the surface of the pad. Specifically, as compared to the pad with a rough surface, the pad with a smooth surface can be firmly bonded to the solder paste. In one aspect, the larger friction coefficient increases the friction force between the pad and the solder paste, and the bonding between the pad and the solder paste can be thus increased owing to the strong interaction force between the pad and the solder paste. In the other aspect, the increase of the friction coefficient indicates that the surface of the pad is not even; for example, a portion of the pad is recessed indicates that a corresponding portion of the solder paste is protruding, while a portion of the pad is protruding indicates that a corresponding portion of the solder paste is recessed. Under such configuration, the solidified solder paste and the pad can be "engaged" or "mated" with each other, so that the cut-off force between the pad and the solder paste can be increased. Therefore, in some embodiments, in order to allow the flip LED chip to be firmly soldered on the wiring board, the bottom portion of the pad is configured to have a greater friction coefficient. For example, the friction coefficient of the bottom portion of the pad may be greater than the friction coefficient of the current spreading layer which is integrally formed with the pad. For example, the friction coefficient of the bottom portion of the N electrode pad is greater than the friction coefficient of the N-type current spreading layer, and the friction coefficient of the bottom portion of the P electrode pad is greater than the friction coefficient of the P-type current spreading layer. In some embodiments, the friction coefficient of the bottom portion of the pad is greater than the friction coefficient of the N-type current spreading layer and the friction coefficient of the P-type current spreading layer.

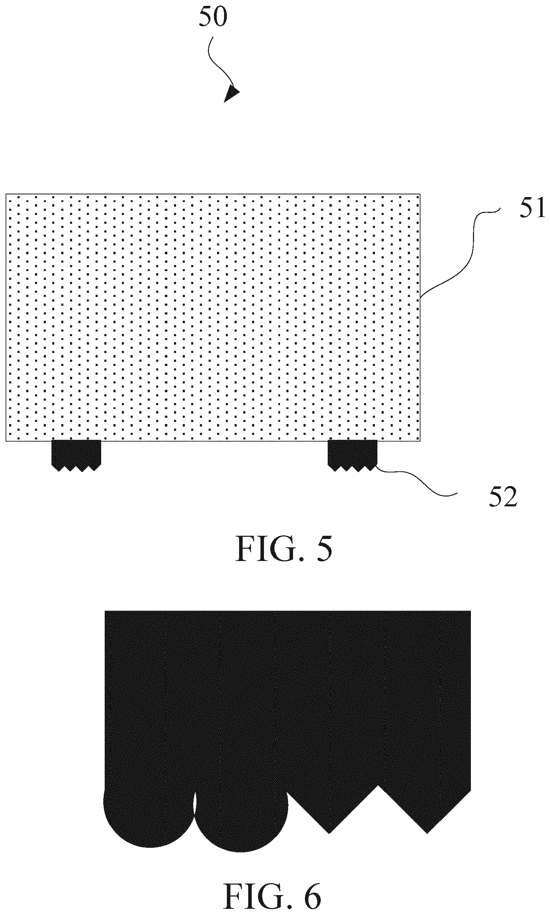

Please refer to the structure of the flip LED chip shown in Fig. 5. In the flip LED chip 50 shown in Fig. 5, the configuration between the pad 52 and the chip body 51 is similar to the configuration of the flip LED chip 10 shown in Fig. 1. However, in Fig. 5, the bottom portion of the pad of the flip LED chip 50 is zigzag or wavy shaped. It is understood that, in Fig. 5, the bottom surface of the pad 52 is of a triangular zigzag shape; however, in some other embodiments, the bottom surface of the pad 52 may be of a rectangular zigzag shape, or even a combination shape of the triangular zigzag shape and the rectangular zigzag shape, or a combination shape of a zigzag shape and a wavy shape. For example, another structure of the flip LED chip is shown in Fig. 6. Of course, in some embodiments, the zigzag shape of the bottom portion of the pad may have other shapes, and all possible examples are not iterated here.

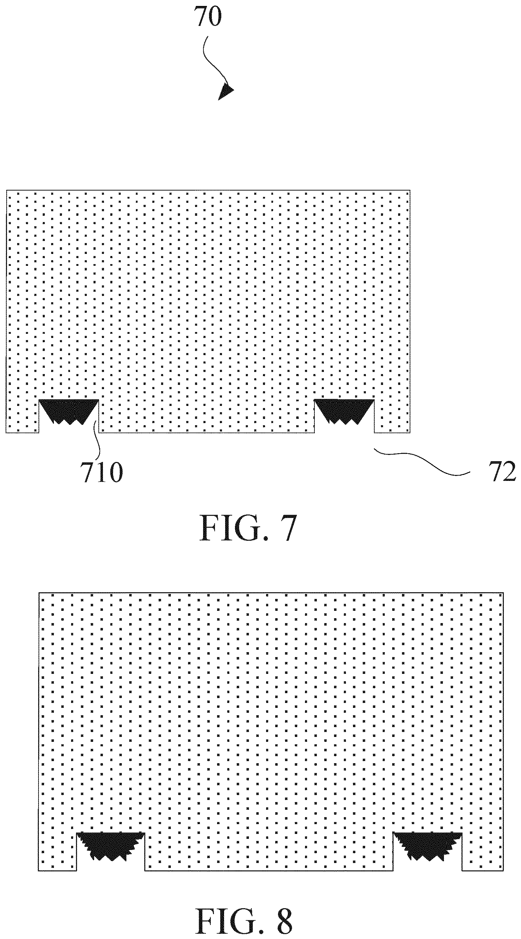

In some embodiments, such configuration for increasing the friction coefficient of the surface of the pad can be applied to the flip LED chip. For example, in Fig. 7, in the flip LED chip 70, the bottom surface of the pad 72 is rough, and the friction coefficient of the bottom surface of the pad 72 is greater than the corresponding current spreading layer. Therefore, for the flip LED chip 70, not only the bonding between the pad 72 and the solder paste can be improved by allowing the solder paste to penetrate the gap between the pad 72 and the pad slot, but also the cut-off force between the pad 72 and the solder paste can be increased by the mating between the bottom zigzag-shaped surface of the pad 72 and the solder paste. Therefore, the reliability for soldering the flip LED chip 70 can be improved.

Although in Fig. 5 to Fig. 7, only the friction coefficient of the bottom surface of the pad increases, in some other embodiments, in addition to increasing the friction coefficient of the bottom surface of the pad, the friction coefficient of the side surface of the pad increases. Alternatively, in some embodiments, both the friction coefficient of the bottom surface of the pad and the friction coefficient of the side surface of the pad can be increased at the same time. For example, in some embodiments, as shown in Fig. 8, the side surface of the pad may be of a zigzag shape, such as a triangular zigzag shape, a rectangular zigzag shape, or a combination shape of the triangular zigzag shape and the rectangular zigzag shape.

It is understood that, in this embodiment, one LED chip comprises two pads, and the configurations of the two pads may be not the same. For example, in some embodiments, the height of one of the pads is equal to the depth of the corresponding pad slot, and the height of the other pad is less than the depth of the corresponding pad slot. In some embodiments, the surface of one of the pads is rougher, and the surface of the other pad is smoother. In some embodiments, the surface of the pad is of a triangular zigzag shape, and the surface of the other pad is of a rectangular zigzag shape.

According to one or some embodiments of the present disclosure, the bottom portion of the chip body is provided with pad slots recessed upwardly for disposing the pads, and the height of the pad is less than or equal to the corresponding pas slot, so that a gap is between the side surface of the pad and the side wall of the pad slot. Therefore, the pads of the flip LED chip are received in the bottom portion of the chip body, rather than being protruding from the bottom portion of the chip body. Therefore, when the pad and the wiring board are soldered with each other by using the solder paste, the solder paste can penetrate the gap between the pad and the pad slot, so that the solder paste, the side surface of the pad, and the side wall of the pad slot can be bonded with each other. Therefore, the interaction force between the pad and the solder paste can be increased, thus increasing the reliability of the bonding between the pad and the wiring board.

Moreover, the friction coefficients of the bottom surface and the side surface of the pad of the flip LED chip may be configured to be a greater value. For example, the bottom surface of the pad or the bottom surface and the side surface of the pad are configured as zigzag shaped. Therefore, in one aspect, the contact area between the pad and the solder paste can be increased, thereby increasing the friction force between the pad and the solder paste. Moreover, such configuration allows the surface of the pad and the solder paste to be firmly engaged with each other, thereby increasing the cut-off force between the pad and the solder paste. Therefore, the production yield of electronic products comprising the flip LED chips can be improved.

### Embodiment (2):

For the sake of showing the advantages and details of the flip LED chip in the aforementioned embodiments, in this embodiment, the details of the flip LED chips are further described.

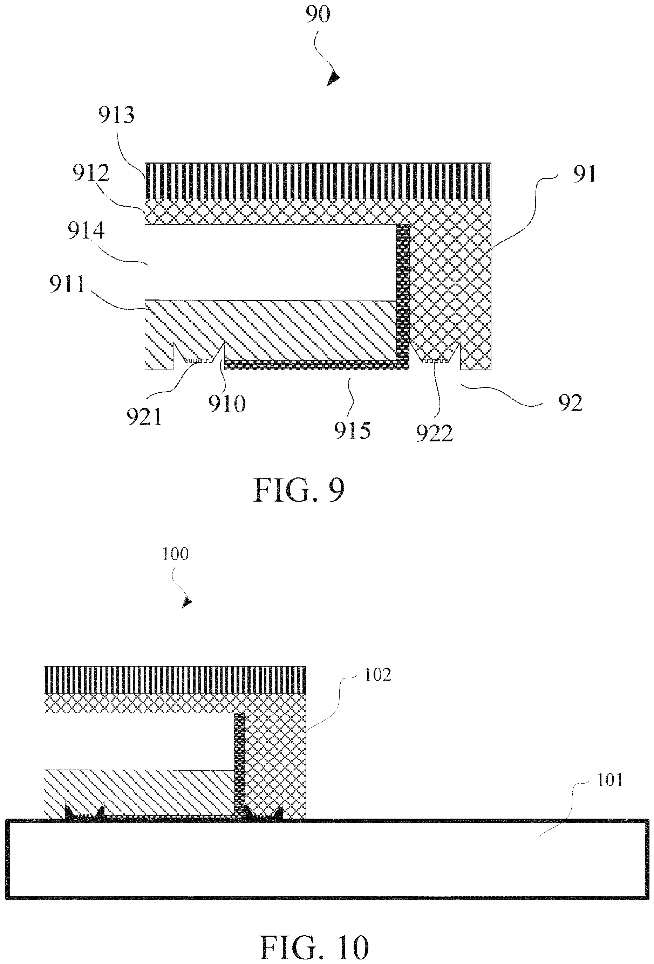

Please refer to the flip LED chip 90 shown in Fig. 9. The flip LED chip 90 comprises a chip body 91 and pads 92. The pads 92 comprise an N electrode pad 921 and a P electrode pad 922. The N electrode pad 921 is integrally formed with the N-type current spreading layer 911 of the chip body 91, and the P electrode pad 922 is integrally formed with the P-type current spreading layer 912 of the chip body 91.

In addition to the N-type current spreading layer 911 and the P-type current spreading layer 912, the chip body 91 may further comprise a transparent protection layer 913, a light-emitting layer 914, and an isolation belt 915. The N-type current spreading layer 911, the light-emitting layer 914, and the P-type current spreading layer 912 are sequentially disposed below the transparent protection layer 913, from top to bottom. The transparent protection layer 913 is provided for protecting the N-type current spreading layer 911, the light-emitting layer 914, and the P-type current spreading layer 912. Therefore, it is understood that, in this embodiment, the transparent protection layer 913 has a greater hardness. In some embodiments, the transparent protection layer 913 may be a sapphire layer.

In this embodiment, an intersection between the N-type current spreading layer 911 and the P-type current spreading layer 912 forms a P-N junction. Likewise, the N electrode pad 921 and the P electrode pad 922 are isolated with each other through the isolation belt 915. As shown in Fig. 9, the N-type current spreading layer 911 and the P-type current spreading layer 912 are separated by the isolation belt 915, and the N electrode pad 921 and the P electrode pad 922 are also separated by the isolation belt 915. The isolation belt 915 shown in Fig. 9 is of an inversed L shape. Therefore, in this embodiment, the isolation belt 915 comprises a vertical portion and a horizontal portion. through the vertical portion of the isolation belt 915, the N-type current spreading layer 911 can be separated from the P-type current spreading layer 912, and the N electrode pad 921 can be separated from the P electrode pad 922. For ensuring the two pads from being conducted with each other during the soldering process, the horizontal portion of the isolation belt 915 is provided at the horizontal direction.

When the flip LED chip 90 is soldered on the wiring board and is applied with currents, the light-emitting layer 914 can emit light under the excitation of the N-type current spreading layer 911 and the P-type current spreading layer 912. The color of the light emitted by the light-emitting layer 914 is related to the material of the current spreading layer (that is, related to the material of the N electrode pad 921 and the P electrode pad 922). In this embodiment, both the materials of the N-type current spreading layer 911 and the P-type current spreading layer 912 are gallium nitride. Of course, in some embodiments, the N-type current spreading layer 911 and the P-type current spreading layer 912 may be made of, for example, gallium arsenide.

In this embodiment, corresponding pad slots 910 are disposed on the bottom of the chip body 91 to correspond to the N electrode pad 921 and the P electrode pad 922. The two pads 92 respectively correspond to the two pad slots 910. The pad slot 910 is recessed upwardly, and the pad 92 extends along a direction from the bottom of the pad slot 910 to the opening of the pad slot 210. However, in this embodiment, the depth of the pad slot 210 is slightly greater than the height of the pad 92. Therefore, the pad 92 does not extend above the opening of the pad slot 910. In some embodiments, the side wall of the pad slot 910 is vertically configured, a certain gap is between the pad 92 and the side wall of the pad slot 910, and the gap gradually increases from the bottom of the pad slot 910 to the opening of the pad slot 910. In other words, in these embodiments, the cross-sectional area of the pad 92 gradually decreases from the bottom of the pad slot 910 to the opening of the pad slot 910.

In this embodiment, the pad 92 is engaged in the pad slot 910. Therefore, upon soldering the flip LED chip 90, the melted solder paste penetrates the gap between the pad 92 and the pad slot 910 easily to contact the side surface of the pad 92. Therefore, the contact area between the pad 92 and the solder paste is increased, thereby increasing the cut-off force between the pad 92 and the solder paste.

In order to further increase the reliability of the soldering of the flip LED chip 90, in this embodiment, the friction coefficient of the surface of the pad 92 is configured to be a greater value. For example, in Fig. 9, both the side surface and the bottom surface of the pad 92 are wavy shaped. Therefore, through configuring the bottom surface and the side surface of the pad 92 from smooth to wavy, the contact area between the pad 92 of the flip LED chip and the solder paste can be increased, thereby increasing the pushing force of the flip LED chip and ensuring the product quality and reliability.

### Embodiment (3):

In this embodiment, a wiring board is provided. Please refer to Fig. 10. The wiring board 100 comprises a substrate 101 and at least one flip LED chip 102. The structure of the flip LED chip 102 can be referred to aforementioned embodiments and is not iterated here. A circuitry is in the substrate 101, and a surface of the substrate 101 comprises a chip configuration region. The flip LED chip 102 may be soldered in the chip configuration region through the solder paste, so that the flip LED chip 102 is electrically connected to the circuitry in the substrate 101.

Upon soldering the flip LED chip 102 to the chip configuration region, the melted solder paste is not only bonded to the bottom surface of the pad of the flip LED chip 102, but also penetrate the gap between the pad and the side wall of the pad slot, so that the solder paste is bonded to the side surface of the pad. Therefore, the contact area between the solder paste and the pad of the flip LED chip 102 can be increased by a certain extent, thereby increasing the bonding between the solder paste and the pad.

Moreover, in some embodiments, at least one of the bottom surface and the side surface of the pad of the flip LED chip 102 is rougher and of a wavy shape and/or a zigzag shape. Hence, not only the contact area between the pad and the solder paste can be increased so that the friction force between the pad and the solder paste can be increased as well, but also the surface of the pad and the solder paste can be engaged with each other, thereby improving the cut-off force between the pad and the solder paste.

Moreover, according to one embodiment of the present disclosure, an electronic apparatus is also provided. The electronic apparatus may be an outdoor LED display or any terminal device. Here, the terminal device may be a portable terminal device such as, a mobile phone, a tablet computer, a notebook computer, a handheld computer, a personal digital assistant (PDA), a portable media player (PMP), a navigation device, a wearable device, a smart wristband, or a pedometer and a fixed terminal device such as a digital TV or a desk computer. In this embodiment, the electronic apparatus comprises the wiring board shown in Fig. 10.

According to the wiring board and the electronic apparatus of one or some embodiments of the present disclosure, owing to the improvement of the pad of the flip LED chip adopting the wiring board and the electronic apparatus, the product reliability can be increased, the product service life can be prolonged, and the product quality can be increased.

It is no doubt that, the flip LED chips according to the aforementioned embodiments can be applied to various light-emitting fields. For example, the chips can be manufactured as backlight modules for backlight display applications (the backlight module may be the backlight module of a terminal device such as a TV, a display, and a mobile phone). In addition to being applied to the display backlight field, the chips can also be applied in the key backlight field, the photographing field, the home lighting field, the medical lighting field, the decoration field, the automobile field, the transportation field, and the like. Upon applying the chips in the key backlight field, the chips can be provided as the key backlight sources for the mobile phone, the computer, or the keyboard. Upon applying the chips in the photographing field, the chips can be manufactured as the flashlights of cameras. Upon applying the chips in the home lighting field, the chips can be manufactured as floor lamps, desk lamps, illumination lamps, ceiling lamps, downlights, projection lamps, or the like. Upon applying the chips in the medical lighting field, the chips can be manufactured as surgical lights or illumination lamps with low electromagnetic interferences. Upon applying the chips in the decoration field, the chips can be manufactured as various decoration lamps such as lights emitting various colors, landscape lamps, or advertising light boxes. Upon applying the chips in the automobile field, the chips can be manufactured as various traffic lights or streetlights. The aforementioned applications are exemplary applications, and the applications of the chips are not limited thereto.

The invention has been described above in terms of the embodiments, and it should be understood by those skilled in the art that the present invention is not intended to limit the scope of the invention. It should be noted that variations and permutations equivalent to those of the embodiments are intended to be within the scope of the present invention. Therefore, the scope of the invention is defined by the scope of the appended claims.

## Claims

1. A flip LED chip (20, 50, 70, 90, 102), **characterized in that** the flip LED chip (20, 50, 70, 90, 102) comprises: a chip body (21, 51, 91) and pads (22, 52, 72, 92) disposed on a bottom portion of the chip body (21, 51, 91), wherein the pads comprise an N electrode pad (221, 921) and a P electrode pad (222, 922); the bottom portion of the chip body (21, 51, 91) is provided with two pad slots (210, 710, 910) recessed upwardly, the N electrode pad (221, 921) is disposed on a bottom of one of the two pad slots (210, 910), the P electrode pad (222, 922) is disposed on a bottom of the other of the two pad slots (210, 710, 910), and a gap is between a side surface of each of the pads (22, 52, 72, 92) and a side wall of a corresponding pad slot (210, 710, 910) of the two pad slots (210, 710, 910).

2. The flip LED chip (20, 50, 70, 90, 102) according to claim 1, wherein an absolute value of a difference between a height (h) of each of the pads (22, 52, 72, 92) and a depth (d) of the corresponding pad slot (210, 710, 910) is less than or equal to 20 µm.

3. The flip LED chip (20, 50, 70, 90, 102) according to claim 2, wherein the height (h) of each of the pads (22, 52, 72, 92) is less than or equal to the depth (d) of the corresponding pad slot (210, 710, 910).

4. The flip LED chip (20, 50, 70, 90, 102) according to claim 1, wherein a cross-sectional area of each of the pads (22, 52, 72, 92) gradually decreases from the bottom of the corresponding pad slot (210, 710, 910) to an opening of the corresponding pad slot (210, 710, 910) distant from the bottom of the corresponding pad slot (210, 710, 910).

5. The flip LED chip (20, 50, 70, 90, 102) according to claim 1, wherein a longitudinal-sectional area of each of the pads (22, 52, 72, 92) is of an inverse isosceles trapezoidal shape or a rectangular shape.

6. The flip LED chip (20, 50, 70, 90, 102) according to claim 1, wherein the side wall of each of the pad slots (210, 710, 910) is perpendicular to the bottom surface of the chip body (21, 51, 91), or a cross-sectional area of each of the pad slots (210, 710, 910) gradually increases from the bottom of the pad slot (210, 710, 910) to the opening of the pad slot (210, 710, 910).

7. The flip LED chip (20, 50, 70, 90, 102) according to claim 1, wherein the gap between the side surface of each of the pads (22, 52, 72, 92) and the side wall of the corresponding pad slot (210, 710, 910) gradually increases from the bottom of the corresponding pad slot (210, 710, 910) to the opening of the corresponding pad slot (210, 710, 910) distant from the bottom of the corresponding pad slot (210, 710, 910).

8. The flip LED chip (20, 50, 70, 90, 102) according to any claim from claims 1 to 7, wherein a friction coefficient of a bottom portion of each of the pads (22, 52, 72, 92) is greater than a friction coefficient of the bottom portion of the chip body (21, 51, 91).

9. The flip LED chip (20, 50, 70, 90, 102) according to claim 8, wherein the bottom surface and/or the side surface of each of the pads (22, 52, 72, 92) is zigzag-shaped or wavy-shaped.

10. A wiring board (100), **characterized in that** the wiring board (100) comprises: a substrate (101) and a flip LED chip (20, 50, 70, 90, 102) according to any claim from claims 1 to 9; wherein the pads (22, 52, 72, 92) of the flip LED chip (20, 50, 70, 90, 102) are soldered to a chip configuration region of the substrate (101) and electrically connected to a circuitry inside the substrate (101).

11. An electronic apparatus, **characterized in that** the electronic apparatus comprises a wiring board (100) according to claim 10.
